# EUROPEAN PATENT APPLICATION

(11) **EP 4 657 482 A1**
(43) Date of publication of application: **03.12.2025**
(21) Application number: 25178571.3
(22) Date of filing: 23.05.2025
(51) Int. Cl.: H01H 19/11, H01H 19/14, H01H 19/46

(54) **ELECTRONIC DEVICE**

(30) Priority: 28.05.2024 CN 202410669127
(71) Applicant: Getac Technology Corporation, New Taipei City 221009 (TW)
(72) Inventor: WU, Ssu-Yuan, 221009 New Taipei City (TW)
(74) Representative: Lucke, Andreas

(57) **Abstract**

An electronic device includes a housing, first and second turntables, first and second fixing members, first engaging structures, a second engaging structure, third engaging structures, and a fourth engaging structure. The first turntable is rotatably disposed on the housing. The first and second fixing members are fixed to the housing. The first engaging structures are disposed on one of the first turntable and the first fixing member. The second engaging structure is disposed on another of the first turntable and the first fixing member and configured to engage with the first engaging structures. The second turntable is rotatably disposed on the first turntable. The third engaging structures are disposed on one of the second turntable and the second fixing member. The fourth engaging structure is disposed on another of the second turntable and the second fixing member and configured to engage with the third engaging structures.

## Description

### BACKGROUND

### Technical Field

The present disclosure relates to an electronic device, and more particularly, to an electronic device that includes a plurality of turntables.

### Description of Related Art

As the functions of electronic devices become increasingly complex, numbers of switches mounted on the electronic devices are also gradually increasing. These switches are generally used to provide various functions of the electronic devices, such as power switching, volume controlling, function switching, and etc. These switches are usually disposed at different positions of the electronic devices. For example, a power switch is often located on the top or side of an electronic device and a function switch key is usually located on the front or back of the electronic device.

However, these designs will occupy more space and reduce the space utilization efficiency of the electronic device. Moreover, it is not convenient for users to operate, and the users need to spend a lot of time to find and operate each switch.

Accordingly, how to provide an electronic device to solve the foregoing problems becomes an important issue to be solved by those in the industry.

### SUMMARY

An aspect of the disclosure is to provide an electronic device to solve the foregoing problems.

According to an embodiment of the disclosure, an electronic device includes a housing, a first turntable, a first fixing member, a plurality of first engaging structures, a second engaging structure, a second turntable, a second fixing member, a plurality of third engaging structures, and a fourth engaging structure. The first turntable is rotatably disposed on the housing. The first fixing member is fixed to the housing. The first engaging structures are disposed on one of the first turntable and the first fixing member. The second engaging structure is disposed on the other one of the first turntable and the first fixing member and configured to engage with any one of the first engaging structures. The second turntable is rotatably disposed on the first turntable. The second fixing member is fixed to the housing. The third engaging structures are disposed on one of the second turntable and the second fixing member. The fourth engaging structure disposed on the other one of the second turntable and the second fixing member and configured to engage with any one of the third engaging structures.

In one or more embodiments of the present disclosure, each of the housing and the first turntable has a wall portion. The wall portion of the housing is rotatably sleeved with the wall portion of the first turntable.

In one or more embodiments of the present disclosure, the housing has a groove. The wall portion of the housing is disposed at an inner edge of the groove. The first turntable includes a protruding wall. The wall portion of the first turntable is disposed at an outer edge of the protruding wall.

In one or more embodiments of the present disclosure, each of the first turntable and the second turntable has a wall portion. The wall portion of the first turntable is rotatably sleeved with the wall portion of the second turntable.

In one or more embodiments of the present disclosure, the first turntable has a through hole. The wall portion of the first turntable is disposed at an inner edge of the through hole. The second turntable includes a boss. The wall portion of the second turntable is disposed at an outer edge of the boss.

In one or more embodiments of the present disclosure, the electronic device further includes a fastening member fastening the second fixing member to the housing.

In one or more embodiments of the present disclosure, each of the first turntable and the second turntable has a through hole. The second fixing member and the housing are fixed to each other through the through hole of the second turntable and the through hole of the first turntable.

In one or more embodiments of the present disclosure, the first engaging structures are engaging holes disposed on the first turntable. The second engaging structure is an engaging block disposed on the first fixing member.

In one or more embodiments of the present disclosure, the first fixing member is an elastic piece. The second engaging structure is an extruded convex structure on the first fixing member.

In one or more embodiments of the present disclosure, the third engaging structures are a plurality of engaging grooves arranged in an annular shape. The fourth engaging structure is an engaging block disposed on the second fixing member.

In one or more embodiments of the present disclosure, the second fixing member is an elastic piece. The fourth engaging structure is an extruded convex structure on the second fixing member.

In one or more embodiments of the present disclosure, one of the housing and the first turntable has a retaining groove. The other one of the housing and the first turntable has a retaining block. The retaining block is slidably engaged in the retaining groove.

In one or more embodiments of the present disclosure, the first turntable is configured to rotate relative to the housing based on an axis. The second turntable is configured to rotate relative to the first turntable based on the axis.

According to an embodiment of the disclosure, an electronic device includes a housing, a first turntable, and a second turntable. The first turntable is rotatably disposed on the housing and configured to rotate relative to the housing based on an axis. The second turntable is rotatably disposed on a side of the first turntable away from the housing and configured to rotate relative to the first turntable based on the axis.

In one or more embodiments of the present disclosure, the electronic device further includes a first fixing member, a plurality of first engaging structures, a second engaging structure, a second fixing member, a plurality of third engaging structures, and a fourth engaging structure. The first fixing member is fixed to the housing. The first engaging structures are disposed on a lateral side of one of the first turntable and the first fixing member. The second engaging structure is disposed on the other one of the first turntable and the first fixing member and configured to engage with any one of the first engaging structures. The second fixing member is fixed to the housing. The third engaging structures are disposed on one of the second turntable and the second fixing member in an annular shape. The fourth engaging structure is disposed on the other one of the second turntable and the second fixing member and configured to engage with any one of the third engaging structures.

Accordingly, in the electronic device of the present disclosure, the first turntable is rotatably disposed on the housing, and the second turntable is rotatably disposed on the first turntable, thereby forming a stacked turntable assembly. The stacked turntable assembly can greatly improve the space utilization efficiency of the electronic device and is more convenient for users to intuitively operate when used as a switch. Any one of the plurality of first engaging structures disposed on one of the first turntable and the first fixing member can be engaged with a second engaging structure disposed on the other one of the first turntable and the first fixing member, thereby forming a multi-step turntable assembly. Each step of the multi-step turntable assembly can cooperate with a switch element, so as to realize different switch functions. Any one of the plurality of third engaging structures disposed on one of the second turntable and the second fixing member and arranged in an annular shape can be engaged with a third engaging structure disposed on the other one of the second turntable and the second fixing member, thereby forming a stepless turntable assembly. The clockwise rotation and counterclockwise rotation of the stepless turntable assembly can cooperate with a switch element to provide different switch functions.

It is to be understood that both the foregoing general description and the following detailed description are by examples, and are intended to provide further explanation of the disclosure as claimed.

### BRIEF DESCRIPTION OF THE DRAWINGS

The disclosure can be more fully understood by reading the following detailed description of the embodiment, with reference made to the accompanying drawings as follows:
Fig. 1A is a perspective view of an electronic device according to an embodiment of the present disclosure;
Fig. 1B is an exploded view of the electronic device in Fig. 1A;
Fig. 2A is a partial front view of some components of the electronic device in Fig. 1A;
Fig. 2B is another partial front view of the components in Fig. 2A;
Fig. 2C is another partial front view of the components in Fig. 2A;
Fig. 3 is a cross-sectional view of the components in Fig. 2A taken along line 3-3;
Fig. 4A is a cross-sectional view of some components of the electronic device in Fig. 1A taken along line 4A-4A; and
Fig. 4B is another cross-sectional view of the components in Fig. 4A.

### DETAILED DESCRIPTION

Reference will now be made in detail to the present embodiments of the disclosure, examples of which are illustrated in the accompanying drawings. Wherever possible, the same reference numbers are used in the drawings and the description to refer to the same or like parts. However, specific structural and functional details disclosed herein are merely representative for purposes of describing example embodiments, and thus may be embodied in many alternate forms and should not be construed as limited to only example embodiments set forth herein. Therefore, it should be understood that there is no intent to limit example embodiments to the particular forms disclosed, but on the contrary, example embodiments are to cover all modifications, equivalents, and alternatives falling within the scope of the disclosure.

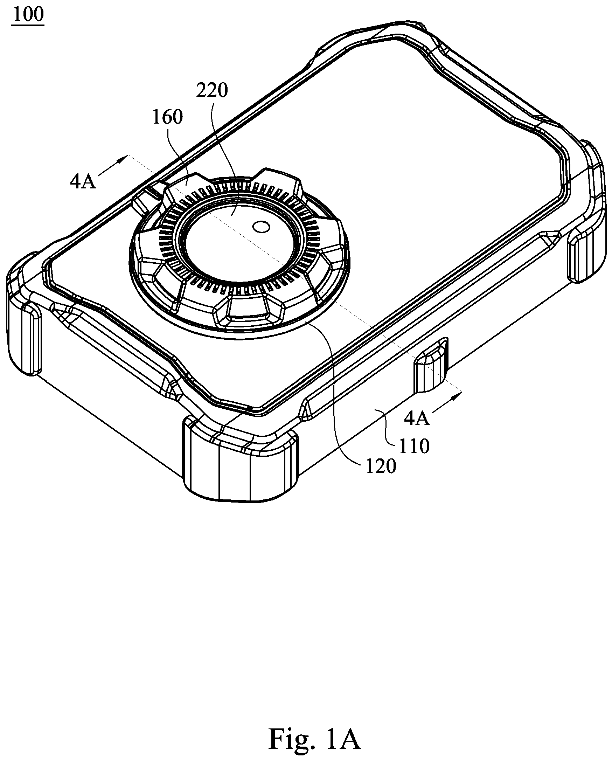

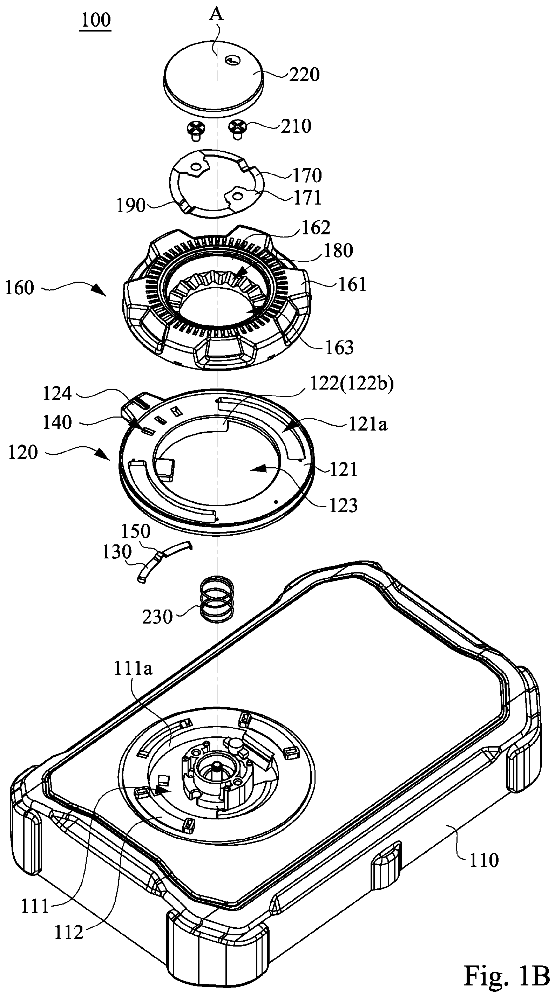

Reference is made to Fig. 1A and Fig. 1B. Fig. 1A is a perspective view of an electronic device 100 according to an embodiment of the present disclosure. Fig. 1B is an exploded view of the electronic device 100 in Fig. 1A. As shown in Fig. 1A and Fig. 1B, the electronic device 100 includes a housing 110, a first turntable 120, and a second turntable 160. The first turntable 120 is rotatably disposed on the housing 110. The second turntable 160 is rotatably disposed on the first turntable 120. In detail, the first turntable 120 is configured to rotate relative to the housing 110 based on an axis A. The second turntable 160 is configured to rotate relative to the first turntable 120 based on the same axis A. The axis A passes through the first turntable 120 and the second turntable 160. In other words, the first turntable 120 and the second turntable 160 rotate around the same central axis. In this way, the housing 110, the first turntable 120, and the second turntable 160 can form a stacked turntable assembly, thereby greatly improving the space utilization efficiency of the electronic device 100. Furthermore, the stacked turntable assembly is more convenient for users to operate intuitively when used as a switch.

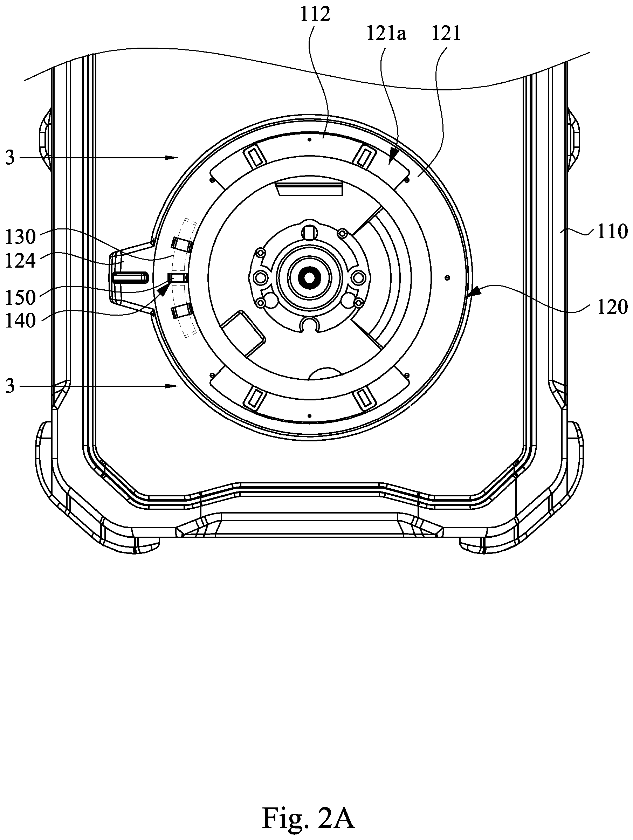

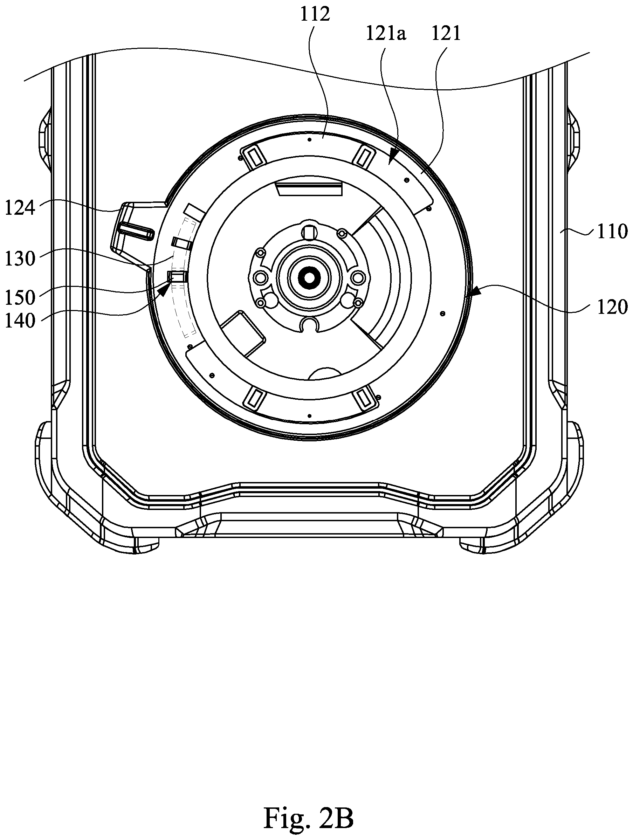

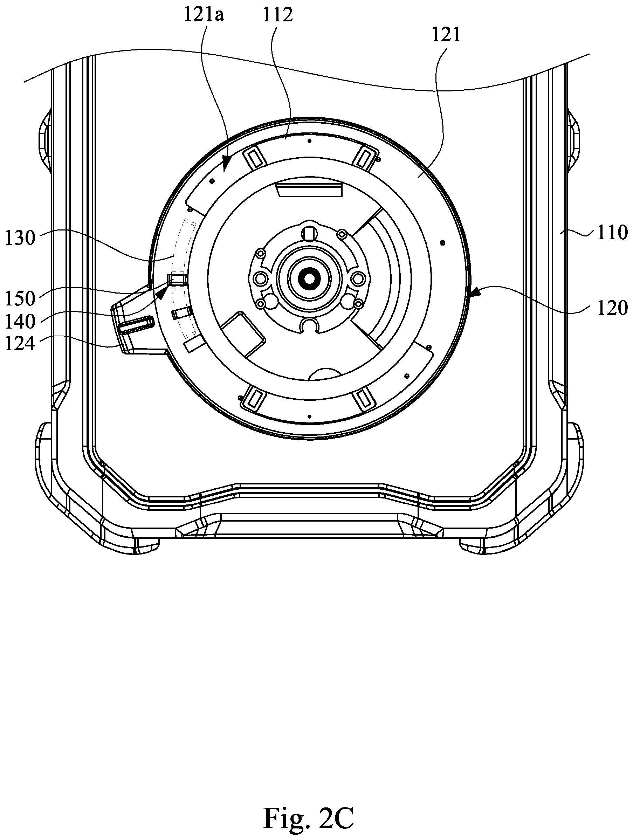

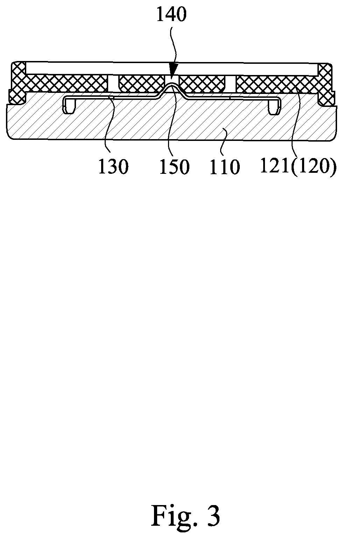

Reference is made to Fig. 2A, Fig. 2B, Fig. 2C, and Fig. 3. Fig. 2A is a partial front view of some components of the electronic device 100 in Fig. 1A. Fig. 2B is another partial front view of the components in Fig. 2A. Fig. 2C is another partial front view of the components in Fig. 2A. Fig. 3 is a cross-sectional view of the components in Fig. 2A taken along line 3-3. As shown in Fig. 1B to Fig. 3, the electronic device 100 further includes a first fixing member 130, a plurality of first engaging structures 140, and a second engaging structure 150. The first fixing member 130 is fixed to the housing 110. Specifically, the first fixing member 130 is fixed to the housing 110 in an engaging manner, but the present disclosure is not limited thereto. The first engaging structures 140 are disposed on the first turntable 120. The second engaging structure 150 is disposed on the first fixing member 130 and configured to engage with any one of the first engaging structures 140. In this way, as shown in Fig. 2A to Fig. 2C, the first turntable 120, the first fixing member 130, the first engaging structures 140, and the second engaging structure 150 can form a multi-step turntable assembly. Each step of the multi-step turntable assembly can cooperate with a switch element, so as to realize different switch functions.

As shown in Fig. 3, the first engaging structures 140 are engaging holes disposed on the first turntable 120. The second engaging structure 150 is an engaging block disposed on the first fixing member 130. Although the engaging holes shown in Fig. 3 are through holes, they can be changed into grooves (i.e., they do not penetrate the first turntable 120) in practical applications.

As shown in Fig. 1B, the first fixing member 130 is an elastic piece. The second engaging structure 150 is an extruded convex structure on the first fixing member 130. In other words, the first fixing member 130 and the second engaging structure 150 form a unitary structure. In this way, the second engaging structure 150 has the ability to deform under force, so that it can move more smoothly between different first engaging structures 140. In detail, when the first turntable 120 rotates to make the bottom surface thereof contact the second engaging structure 150, the second engaging structure 150 is compressed and elastically deformed; when the first turntable 120 rotates to move the second engaging structure 150 to one of the first engaging structures 140, the second engaging structure 150 elastically recovers and engages with the first engaging structure 140.

In some embodiments, a material of the aforementioned unitary structure includes metal, for example. In this way, the durability of the second engaging structure 150 can be improved.

In some embodiments, the first fixing member 130, the second engaging structure 150, and the housing 110 may form a unitary structure. A material of the unitary structure includes plastic, for example, and may be manufactured by, for example, an injection molding process. The first fixing member 130 is an elastic piece with two ends connected to the housing 110, and the second engaging structure 150 is a protruding structure on the first fixing member 130.

As shown in Fig. 2A to Fig. 2C, a number of the first engaging structures 140 is three, but the present disclosure is not limited thereto. In practical applications, the number of the first engaging structures 140 can be flexibly changed according to requirements.

In practical applications, the first engaging structures 140 may be disposed on the housing 110, and the first fixing member 130 and the second engaging structure 150 may be disposed on the first turntable 120, which can also achieve the function of the aforementioned multi-step turntable assembly. In practical applications, the first engaging structures 140 may be disposed on the first fixing member 130, and the second engaging structure 150 may be disposed on the first turntable 120, which can also achieve the function of the aforementioned multi-step turntable assembly.

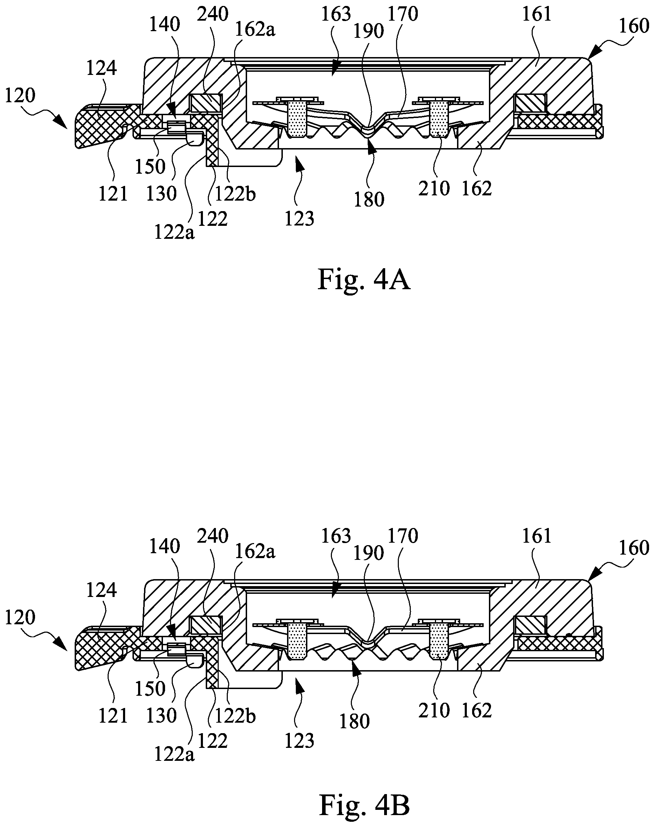

Reference is made to Fig. 4A and Fig. 4B. Fig. 4A is a cross-sectional view of some components of the electronic device 100 in Fig. 1A taken along line 4A-4A. Fig. 4B is another cross-sectional view of the components in Fig. 4A. As shown in Fig. 1B, Fig. 4A, and Fig. 4B, the housing 110 has a wall portion 111a, and the first turntable 120 has a wall portion 122a. The wall portion 111a of the housing 110 is rotatably sleeved with the wall portion 122a of the first turntable 120. Specifically, the housing 110 has a groove 111. The wall portion 111a of the housing 110 is disposed at an inner edge of the groove 111. The first turntable 120 includes a disk body 121 and a protruding wall 122. The disk body 121 of the first turntable 120 is annular and has a through hole 123. The protruding wall 122 of the first turntable 120 is connected to an inner edge of the disk body 121 and extends toward the housing 110. The wall portion 122a of the first turntable 120 is disposed at an outer edge of the protruding wall 122. In this way, the wall portion 111a of the housing 110 is rotatably sleeved onto the wall portion 122a of the first turntable 120, so that the first turntable 120 can rotate around the axis A relative to the housing 110.

In practical applications, the groove 111 of the housing 110 may be disposed on the first turntable 120, and the protruding wall 122 of the first turntable 120 may be disposed on the housing 110, which can also achieve the function of enabling the first turntable 120 to rotate around the axis A relative to the housing 110.

As shown in Fig. 1B, the housing 110 further includes a retaining block 112. The disk body 121 of the first turntable 120 has a retaining groove 121a. The retaining block 112 is slidably engaged in the retaining groove 121a. In this way, when the first turntable 120 rotates relative to the housing 110, the second engaging structure 150 can be prevented from running out of the outermost two of the first engaging structures 140. For example, as shown in Fig. 2B, when one end of the retaining block 112 abuts against one end of the retaining groove 121a, the second engaging structure 150 is engaged with an outer one of the first engaging structures 140. As shown in Fig. 2C, when another end of the retaining block 112 abuts against another end of the retaining groove 121a, the second engaging structure 150 is engaged with another outer one of the first engaging structures 140. In practical applications, the retaining block 112 may be disposed on the first turntable 120, and the retaining groove 121a may be disposed on the housing 110, which can also achieve the aforementioned purpose of preventing the second engaging structure 150 from running out of the outermost two of the first engaging structures 140.

As shown in Fig. 1B, Fig. 4A, and Fig. 4B, the first turntable 120 has a wall portion 122b, and the second turntable 160 has a wall portion 162a. The wall portion 122b of the first turntable 120 is rotatably sleeved with the wall portion 162a of the second turntable 160. Specifically, the wall portion 122b of the first turntable 120 is disposed at an inner edge of the through hole 123. The second turntable 160 includes a disk body 161 and a boss 162. The disk body 161 of the second turntable 160 is annular and has a through hole 163. The boss 162 of the second turntable 160 is connected to an inner edge of the disk body 161 and extends toward the housing 110 and the first turntable 120. The third engaging structures 180 are disposed on a side of the boss 162 away from the housing 110. The wall portion 162a of the second turntable 160 is disposed at an outer edge of the boss 162. In this way, the wall portion 122b of the first turntable 120 can be rotatably sleeved onto the wall portion 162a of the second turntable 160, so that the second turntable 160 can rotate around the axis A relative to the first turntable 120.

In practical applications, the protruding wall 122 of the first turntable 120 may be disposed on the second turntable 160, and the boss 162 of the second turntable 160 may be disposed on the first turntable 120, which can also achieve the function of enabling the second turntable 160 to rotate around the axis A relative to the first turntable 120.

As shown in Fig. 1B, Fig. 4A, and Fig. 4B, the first turntable 120 further includes a toggle piece 124. The toggle piece 124 is connected to an outer edge of the disk body 121. In this way, even though the disk body 121 of the first turntable 120 is overlapped between the housing 110 and the disk body 161 of the second turntable 160, the users can still rotate the first turntable 120 by turning the toggle piece 124.

As shown in Fig. 1B, Fig. 4A, and Fig. 4B, the electronic device 100 further includes a second fixing member 170, a plurality of third engaging structures 180, and a fourth engaging structure 190. The second fixing member 170 is fixed to the housing 110. The third engaging structures 180 are disposed on the second turntable 160. The fourth engaging structure 190 disposed on the second fixing member 170 and configured to engage with any one of the third engaging structures 180. The third engaging structures 180 disposed on the second turntable 160 are arranged in an annular shape. A width of each of the third engaging structures 180 is substantially equal to a distance between adjacent two of the third engaging structures 180. In this way, the second turntable 160, the second fixing member 170, the third engaging structures 180, and the fourth engaging structure 190 can form a stepless turntable assembly. The clockwise rotation and counterclockwise rotation of the stepless turntable assembly can cooperate with a switch element to provide different switch functions.

For example, as shown in Fig. 4A and Fig. 4B, the electronic device 100 further includes a magnet ring 240. The magnet ring 240 is disposed at the bottom of the disk body 161 of the second turntable 160 and is located between the first turntable 120 and the second turntable 160. Therefore, the magnet ring 240 rotates along with the rotation of the second turntable 160. The magnet ring 240 has a plurality of magnetic poles. The magnetic poles of different polarities are arranged alternately along the ring. That is, the N poles and the S poles are arranged alternately to surround. A number of the magnetic poles on the magnet ring 240 can be set according to a number of steps to be adjusted. In addition, a Hall sensor (not shown) corresponding to the magnet ring 240 may be disposed in the housing 110. The Hall sensor can sense the change in magnetic force and output a sensing signal accordingly, thereby realizing the aforementioned switch function.

As shown in Fig. 4A, the third engaging structures 180 are a plurality of engaging grooves arranged in an annular shape. The fourth engaging structure 190 is an engaging block disposed on the second fixing member 170. Although the engaging grooves shown in Fig. 4A are grooves, they can be changed into through holes (i.e., penetrating the second turntable 160) in practical applications. In practical applications, the third engaging structures 180 may be disposed on the second fixing member 170, and the fourth engaging structure 190 may be disposed on the second turntable 160, which can also achieve the function of the aforementioned stepless turntable assembly.

As shown in Fig. 1B, the second fixing member 170 is an elastic piece. The fourth engaging structure 190 is an extruded convex structure on the second fixing member 170. In other words, the second fixing member 170 and the fourth engaging structure 190 form a unitary structure. In this way, the fourth engaging structure 190 has the ability to deform under force, so it can move more smoothly between different third engaging structures 180. In detail, when the second turntable 160 rotates and the fourth engaging structure 190 moves to the junction between adjacent two of the third engaging structures 180, the fourth engaging structure 190 is compressed and elastically deformed; when the second turntable 160 rotates to move the fourth engaging structure 190 to one of the third engaging structures 180, the fourth engaging structure 190 elastically recovers and engages with the third engaging structure 180.

In some embodiments, a material of the unitary structure formed by the second fixing member 170 and the fourth engaging structure 190 includes metal, for example. In this way, the durability of the fourth engaging structure 190 can be improved.

As shown in Fig. 1B, Fig. 4A, and Fig. 4B, the electronic device 100 further includes fastening members 210. The fastening members 210 fasten the second fixing member 170 to the housing 110. Specifically, the second fixing member 170 and the housing 110 are fixed to each other via the through hole 163 of the second turntable 160 and the through hole 123 of the first turntable 120 through the fastening members 210.

As shown in Fig. 1B, the second fixing member 170 is ring-shaped and has two fastening portions 171. The two fastening members 210 pass through the two fastening portions 171 respectively and are fastened to the housing 110, so as to firmly fix the second fixing member 170 and the housing 110 to each other. The two fastening members 210 are symmetrically arranged relative to the second fixing member 170. There are two fourth engaging structures 190, which are symmetrically arranged relative to the second fixing member 170, so that the fourth engaging structures 190 can be stably pressed against the third engaging structures 180 (i.e., without bias).

As shown in Fig. 1B, the electronic device 100 further includes a cover 220. The cover 220 covers the through hole 163 of the second turntable 160, so that the components (such as the second fixing member 170, the third engaging structures 180, the fourth engaging structure 190, the fastening members 210, and etc.) located in the through hole 163 will not be exposed, thereby preventing external dirt from accumulating on these components and hindering the smooth rotation of the first turntable 120 and/or the second turntable 160.

As shown in Fig. 1B, the electronic device 100 further includes a position-returning member 230. The position-returning member 230 is disposed between the housing 110 and the cover 220. In some embodiments, the cover 220 is configured to move toward the housing 110 to a pressed position, and move away from the housing 110 to a released position. The position-returning member 230 is configured to return the cover 220 to the released position. The combination of the cover 220 and the position-returning member 230 can cooperate with a switch element to provide a switch function. That is, the combination of the cover 220 and the position-returning member 230 can be used as a button.

In the present embodiment, the position-returning member 230 is a compression spring, but the present disclosure is not limited thereto. The position-returning member 230 may be other elastic elements.

According to the foregoing recitations of the embodiments of the disclosure, it can be seen that in the electronic device of the present disclosure, the first turntable is rotatably disposed on the housing, and the second turntable is rotatably disposed on the first turntable, thereby forming a stacked turntable assembly. The stacked turntable assembly can greatly improve the space utilization efficiency of the electronic device and is more convenient for users to intuitively operate when used as a switch. Any one of the plurality of first engaging structures disposed on one of the first turntable and the first fixing member can be engaged with a second engaging structure disposed on the other one of the first turntable and the first fixing member, thereby forming a multi-step turntable assembly. Each step of the multi-step turntable assembly can cooperate with a switch element, so as to realize different switch functions. Any one of the plurality of third engaging structures disposed on one of the second turntable and the second fixing member and arranged in an annular shape can be engaged with a third engaging structure disposed on the other one of the second turntable and the second fixing member, thereby forming a stepless turntable assembly. The clockwise rotation and counterclockwise rotation of the stepless turntable assembly can cooperate with a switch element to provide different switch functions.

## Claims

1. An electronic device (100), **characterized by** comprising:
a housing (110);
a first turntable (120) rotatably disposed on the housing (110);
a first fixing member (130) fixed to the housing (110);
a plurality of first engaging structures (140) disposed on one of the first turntable (120) and the first fixing member (130);
a second engaging structure (150) disposed on the other one of the first turntable (120) and the first fixing member (130) and configured to engage with any one of the first engaging structures (140);
a second turntable (160) rotatably disposed on the first turntable (120);
a second fixing member (170) fixed to the housing (110);
a plurality of third engaging structures (180) disposed on one of the second turntable (160) and the second fixing member (170); and
a fourth engaging structure (190) disposed on the other one of the second turntable (160) and the second fixing member (170) and configured to engage with any one of the third engaging structures (180).

2. The electronic device (100) of claim 1, **characterized in that** each of the housing (110) and the first turntable (120) has a wall portion (111a, 122a), and the wall portion (111a) of the housing (110) is rotatably sleeved with the wall portion (122a) of the first turntable (120).

3. The electronic device (100) of claim 2, **characterized in that** the housing (110) has a groove (111), the wall portion (111a) of the housing (110) is disposed at an inner edge of the groove (111), the first turntable (120) comprises a protruding wall (122), and the wall portion (122a) of the first turntable (120) is disposed at an outer edge of the protruding wall (122).

4. The electronic device (100) of one of the preceding claims, **characterized in that** each of the first turntable (120) and the second turntable (160) has a wall portion (122b, 162a), and the wall portion (122b) of the first turntable (120) is rotatably sleeved with the wall portion (162a) of the second turntable (160).

5. The electronic device (100) of claim 4, **characterized in that** the first turntable (120) has a through hole (123), the wall portion (122b) of the first turntable (120) is disposed at an inner edge of the through hole (123), the second turntable (160) comprises a boss (162), and the wall portion (162a) of the second turntable (160) is disposed at an outer edge of the boss (162).

6. The electronic device (100) of one of the preceding claims, **characterized by** further comprising a fastening member (210) fastening the second fixing member (170) to the housing (110).

7. The electronic device (100) of one of the preceding claims, **characterized in that** each of the first turntable (120) and the second turntable (160) has a through hole, and the second fixing member (170) and the housing (110) are fixed to each other through the through hole (1163) of the second turntable (160) and the through hole (123) of the first turntable (120).

8. The electronic device (100) of one of the preceding claims, **characterized in that** the first engaging structures (140) are engaging holes disposed on the first turntable (120), and the second engaging structure (150) is an engaging block disposed on the first fixing member (130).

9. The electronic device (100) of claim 8, **characterized in that** the first fixing member (130) is an elastic piece, and the second engaging structure (150) is an extruded convex structure on the first fixing member (130).

10. The electronic device (100) of one of the preceding claims, **characterized in that** the third engaging structures (180) are a plurality of engaging grooves arranged in an annular shape, and the fourth engaging structure (190) is an engaging block disposed on the second fixing member (170).

11. The electronic device (100) of claim 10, **characterized in that** the second fixing member (170) is an elastic piece, and the fourth engaging structure (190) is an extruded convex structure on the second fixing member (170).

12. The electronic device (100) of one of the preceding claims, **characterized in that** one of the housing (110) and the first turntable (120) has a retaining groove (121a), the other one of the housing (110) and the first turntable (120) has a retaining block (112), and the retaining block (112) is slidably engaged in the retaining groove (121a).

13. The electronic device (100) of one of the preceding claims, **characterized in that** the first turntable (120) is configured to rotate relative to the housing (110) based on an axis (A), and the second turntable (160) is configured to rotate relative to the first turntable (120) based on the axis (A).

14. An electronic device (100), **characterized by** comprising:
a housing (110);
a first turntable (120) rotatably disposed on the housing (110) and configured to rotate relative to the housing (110) based on an axis (A); and
a second turntable (160) rotatably disposed on a side of the first turntable (120) away from the housing (110) and configured to rotate relative to the first turntable (120) based on the axis (A).

15. The electronic device (100) of claim 14, **characterized by** further comprising:
a first fixing member (130) fixed to the housing (110);
a plurality of first engaging structures (140) disposed on a lateral side of one of the first turntable (120) and the first fixing member (130);
a second engaging structure (150) disposed on the other one of the first turntable (120) and the first fixing member (130) and configured to engage with any one of the first engaging structures (140);
a second fixing member (170) fixed to the housing (110);
a plurality of third engaging structures (180) disposed on one of the second turntable (160) and the second fixing member (170) in an annular shape; and
a fourth engaging structure (190) disposed on the other one of the second turntable (160) and the second fixing member (170) and configured to engage with any one of the third engaging structures (180).
